# EUROPEAN PATENT SPECIFICATION

(11) **EP 3 719 154 B1**
(45) Date of publication and mention of the grant of the patent: **06.08.2025**
(21) Application number: 20160383.4
(22) Date of filing: 02.03.2020
(51) Int. Cl.: C22C 19/05, C22F 1/10, F01D 5/28

(54) **NICKEL-BASED SUPERALLOY AND HEAT TREATMENT FOR SALT ENVIRONMENTS**
SUPERLEGIERUNG AUF NICKELBASIS UND WÄRMEBEHANDLUNG FÜR HARSCHE SALZUMGEBUNGEN
SUPERALLIAGE À BASE DE NICKEL ET TRAITEMENT THERMIQUE POUR ENVIRONNEMENTS SALINS

(30) Priority: 05.04.2019 US 201962829821 P
(43) Date of publication of application: 07.10.2020
(73) Proprietor: RTX Corporation, Farmington, CT 06032 (US)
(72) Inventor: CETEL, Alan D., West Hartford, CT Connecticut 06117 (US); SHAH, Dilip M., Glastonbury, CT Connecticut 06033 (US)
(74) Representative: Dehns

(56) References cited:
- US-A- 5 925 198
- US-A1- 2005 067 062
- US-A1- 2007 235 110
- US-A1- 2009 185 944
- US-A1- 2015 292 063

## Description

### BACKGROUND

The disclosure relates to gas turbine engines. More particularly, the disclosure relates to alloy selection and crystalline orientation for gas turbine engine components.

Gas turbine engine hot section components are commonly formed of alloys, typically nickel- or cobalt-based superalloys. Many components, such as blades are formed of single-crystal (SX) alloys. In such single-crystal components, essentially the entire component is formed of a single continuous crystal lattice. Typically, the orientation of that lattice is predetermined to achieve desired properties of the component. The orientation may be assured by use of a grain starter or other casting techniques.

By way of example, U.S. Pat. No. 4,605,452 of Gemma and Dierberger identifies face centered cubic (FCC) single-crystal gas turbine blades wherein the [110] crystal axis is tangent to the blade airfoil surface in a critical crack-prone region just behind the leading edge of the airfoil at about 40-80% of the airfoil span. U.S. Pat. No. 6,074,602 (the '602 patent) of Wukusick and Buchakjian, Jr.**,** identifies a further single-crystal alloy. Table I (discussed below) includes comparative data from an alloy of the '602 patent among others.

US 2005/067062 A1 discloses a prior art single-crystal Ni-based superalloy with high temperature strength, oxidation resistance and hot corrosion resistance.

US 2007/235110 A1 discloses prior art nickel-based superalloys with excellent mechanical strength, corrosion resistance and oxidation resistance.

US 2015/292063 A1 discloses a prior art Ni-based single crystal superalloy and turbine blade incorporating the same.

US 5 925 198 A discloses a prior art nickel-based superalloy.

### SUMMARY

From One aspect of the disclosure, there is provided an alloy as recited in claim 1.

There is also provided a use of a substrate formed of the alloy as recited in claim 7.

There is also provided a method of heat treatment of the alloy as recited in claim 11.

Features of embodiments are set forth in the dependent claims.

The details of one or more embodiments are set forth in the accompanying drawings and the description below. Other features, objects, and advantages will be apparent from the description and drawings, and from the claims.

### BRIEF DESCRIPTION OF THE DRAWINGS

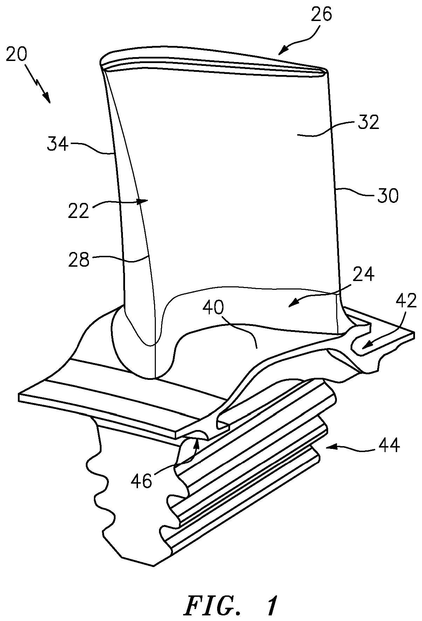

FIG. 1 is a view of a turbine blade.

Like reference numbers and designations in the various drawings indicate like elements.

### DETAILED DESCRIPTION

In FIG. 1, an engine turbine element 20 is illustrated as a blade having an airfoil 22 which extends between an inboard end 24, and an opposing outboard end 26 (e.g., at a free tip), a distance therebetween extending substantially in the engine radial direction. The airfoil also includes a leading edge 28 and an opposing trailing edge 30. A pressure side 32 and an opposing suction side 34 extend between the leading edge 28 and trailing edge 30.

The airfoil inboard end 24 is disposed at the outboard surface 40 of a platform 42. An attachment root 44 extends radially inward from the underside 46 of the platform.

The root 44 has an inner diameter (ID) end or face 48, an upstream axial end 50, a downstream axial end 52, and first and second lateral sides 54 and 56, respectively. The root 44 is complementary to a disk slot (not shown). When fully seated in the disk slot, the faces 50 and 52 may face exactly forward/upstream and rearward/downstream in the engine frame of reference. Depending on disk configuration (slot orientation), the sides may extend parallel to the engine centerline between the axial ends (root having a rectangular footprint/section) or may extend skew (root having a non-right parallelogram footprint) such as in the illustrated example.

The turbine blade is cast of a high temperature alloy, namely a single-crystal Ni-based superalloy discussed below.

The blade may also have a thermal barrier coating (TBC, e.g., one or more layer ceramic atop of one or more layer bondcoat) system along at least a portion of the airfoil.

The blade may have an internal cooling passageway system (not shown) extending from one or more inlets along a root to a plurality of outlets (along or mostly along the airfoil and platform surfaces).

Stress corrosion cracking (SCC) has been a concern in commercial engine turbine blades. Atmospheric salt and pollution appear to be contributing factors. A particular area of SCC is along platform undersides of high pressure turbine (HPT) blades.

A number of alloys were conceived as potentially offering improved resistance to stress corrosion cracking, particularly in salt environments. Table I shows test data for ten candidate alloys (Ex. 1-10) and four prior art alloys (Prior Art 1-4). Of the examples, Ex. 7, 9, and 10 show particular benefits discussed below.

Ex. 9 is an alloy according to the invention and Ex. 1-8 and 10 are reference examples.

In the present disclosure: 1°F is 255.928K; 1ksi is 6.89476 MPa and 1 inch is 2.54 cm.

Table I lists the post-solutioning heat treatments used. For example, "2050F/4+1975F/4+1650F/4" indicates 2050° Fahrenheit for four hours followed by 1975° Fahrenheit for four hours followed by 1650° Fahrenheit for four hours. The solutioning involved heat treatment at or above the alloy gamma prime solvus temperatures for 4.0 hours in the 2350° to 2375° Fahrenheit range.

Rupture tests were performed on creep-rupture specimens with nominal 0.125 inch gauge diameters tested isothermally at 1500F with constant load and low melting eutectic salt mixture brushed on the gauge section every 100 hours. The salt was a quaternary system of sodium, magnesium, potassium, and calcium sulfates with a melting point of about 1200F (e.g., 1175F-1225F or 1195F to 1205F). The salt represents an approximately equal blend of two ternary examples from the cited Du article below (rows 5 and 6 of Table 4 of the Du article). The air rupture test was performed in a furnace drawing in ambient laboratory air; whereas the salt rupture test was performed in a similar arrangement although salt was brushed on the gauge section periodically. Such salt and test procedure may be used as a reference in the tests of the claims below. Alternative reference salts are disclosed in BORNSTEIN, NORMAN S. "Reviewing sulfidation corrosion-Yesterday and today", Journal of Materials (Jom), November, 1996, pages 37-39, Volume 48, Issue No. 11, Springer, Heidelberg, Germany and DU, H., "Thermodynamic assessment of the K2SO4-Na2SO4-MgSO4-CaSO4 system", Journal of Phase Equilibria, January 1, 2000, pages 6-18,Volume 21, Issue No. 1, Springer, Heidelberg, Germany. The disclosures of said Bornstein and Du articles are incorporated by reference in their entireties herein as if set forth at length. Similar relative behavior of alloys and heat treatments would be expected when tested with the Bornstein and Du salts to the results obtained herein.

Two factors to be considered from the tests are absolute rupture life and consistency in rupture life. Because of the relatively close compositions of the examples and prior art, what would otherwise be a statistically insignificantly small sample size of one alloy (e.g., one or two tests) allows a statistically significant conclusion to be made when such small test numbers of many slightly different alloys are considered. Thus, running only two tests each of two alloys would not be statistically significant if one alloy had a 300-hour test life and a 250-hour test life while the other had a 300-hour test life and a 50-hour test life. But, such two-test per alloy data becomes significant when one looks a greater number of alloys. From such data one may statistically significantly determine a compositional range associated with the long life and/or consistent performance. In this case, a compositional range around Ex. 7, 9, and 10 is indicated as having an advantageous combination of life and consistency.

In contrast, consider Ex. 1, 2 and 3 where Cr levels below 6.75% produced instances of lower rupture lives in salted creep testing.

In Table I, the three targeted alloys (Ex. 7, 9, and 10) have significant amounts of the elements Ni, Cr, Mo, W, Ta, Al, Co, and Re. As far as other elements, Ti, C, B, Y, and/or Hf can be added in small amounts to benefit alloy properties. S should be kept as low as possible to benefit oxidation resistance. Small Si additions will also benefit oxidation resistance. Combined Y + Hf + B + Si additions should be maintained below 0.40% to achieve high levels of alloy incipient melting temperature. In terms of individual contents, in exemplary ranges one-to-all of a titanium content, if any, is no more than 0.50%; a boron content, if any, is no more than 0.01%; a yttrium content, if any, is no more than 0.02%; a sulfur content, if any, is no more than 5ppm or no more than 1ppm; a hafnium content, if any is no more than 0.50% or is in the range of 0.050% to 0.15%; a silicon content, if any, is no more than 0.50% or 0.30%; and a carbon content, if any, is no more than 0.10%, by weight.

In various examples, a combined weight content, if any, of elements other than nickel, chromium, cobalt, aluminum, rhenium, tungsten, tantalum, molybdenum, if any, sulfur, if any, hafnium, if any, silicon, if any, and carbon, if any, is no more than 1.0% or 0.75% or 0.50% or 0.40%.

In various examples, the combined weight content of chromium, cobalt, and aluminum is 17.0% to 23.0% or 17.5% to 22.5% or 20.0% to 22.0%.

In terms of heat treatment, from Table I it can be further determined that an advantageous heat treatment involves full or close to full gamma prime solutioning at temperatures at or above 2375F, followed by intermediate heat treatments at 2050F and or 1975F for 4 hours with a final PHT aging heat treatment at 1650F for 4 hours.

As a further refinement, Table III involves exploration of heat treatment parameters with the Prior Art 3 alloy. Solution heat treat is at a temperature between solvus and incipient melting point. At commercial scale to have an effective heat treat, solutioning may be at a temperature of at least 20F over solvus or at least 25F or at least 30F. At the other end, to avoid errors (risk of incipient melting due to process variation), a target solution heat treat may be in the range of not more than 40F below incipient melting or not more than 35F or not more than 30F or not more than 25F.

The Prior Art 3 alloy has a 2440F incipient melting temperature and a 2370F solvus temperature. Exemplary solution heat treat is 2400F up to the incipient melting temperature. At commercial scale to avoid errors, a target solution heat treat may be in the range of 2380F to 2415F. Times of 30 minutes, 4 hours, and 20 hours are given. High consistency is seen at 20 hours. Alternative exemplary lower ends on ranges other than 4 hours are 6 hours and 8 hours. Much above 20 would seem to offer little benefit for cost.

Several pure precipitation heat treatments (PHT) are compared with several solution heat treatments. The latter are followed by a two-stage final heat treatment. In the same salt tests as those of Table I, it is seen that the increasing alloy homogenization by increasing the time at the solution heat treatment temperature reduces variability and increases average life. The post-solutioning final aging heat treatment (a precipitation heat treat (PHT)) also plays a significant role in increasing both the minimum and average rupture life in salt tests. Increasing both the PHT temperature to 1600F and the time to 32 hours produces the highest creep-rupture life in a salt environment.

When transferring this Prior Art 3 experience to the other alloys, adjustments may be made for differences in solutioning temperature and incipient melting point. For example, Examples 7, 9, and 10 have lower solvus and incipient meting temperatures which would have corresponding lower target heat treatment temperatures while preserving times.

Alloys to be used in turbine blade applications require good high temperature creep-rupture strength in an air environment. Key Table I examples also show good high temperature creep-rupture life as shown in testing conducted at 1800F/36ksi and 1850F/38ksi. Although lives are not as good as those in the alloy of Prior Art 3, they are adequate to meet service turbine blade requirements. We infer that these good lives can be maintained by insuring that total W + Ta + Re content stays in the range of 9.0 to 16.5% by weight. Total W + Ta content may more narrowly stay in the range of 12.0% to 13.0% by weight or more broadly 8.0% to 14.0% (with life compromise at the low end).

**Table I**

| Alloy Rupture Tests (Salt and Air) | | | | | | | | | | | | | | | | | | |
|---|---|---|---|---|---|---|---|---|---|---|---|---|---|---|---|---|---|---|
| Up to Two Tests at each of Two Conditions per Heat Treat | | | | | | | | | | | | | | | | | | |
| Tested Alloy | Elemental Weight Percentage | | | | | | | | | | | | | Post-Solution Heat Treat (Temp/Hours) | Test (hours) | | | |
| | | | | | | | | | | | | | | | Salt Rupture | | Air Rupture | |
| | Ni | Cr | Ti | Mo | W | Ta | Al | Co | Re | Hf | C | B | Y | | 1500F-90ksi | 1500F-100ksi | 1800F-36ksi | 1850F-38ksi |
| Ex. 1* | Bal | 6.03 | 0 | 1.94 | 6 | 6.33 | 5.68 | 10.02 | 2.93 | 0.09 | 0.03 | <0.01 | <0.001 | 1975F/4+1500 F/8 | 214.8 | 0.6 | 188.3 | 42.3 |
| | | | | | | | | | | | | | | | 15.3 | 3 | 188.9 | 40.8 |
| | | | | | | | | | | | | | | 2050F/4+1975 F/4+1650F/4 | 240.5 | 3.3 | 202.4 | 43.3 |
| | | | | | | | | | | | | | | | 226.9 | 0.8 | 214.7 | 47.7 |
| | | | | | | | | | | | | | | 1975F/4+1650 F/4 | 235.6 | 105.5 | | |
| | | | | | | | | | | | | | | | 296 | 101.4 | | |
| Ex. 2* | Bal | 6.45 | 0 | 1.93 | 5.89 | 6.27 | 5.65 | 10.04 | 2.99 | 0.09 | 0.03 | <0.01 | <0.001 | 1975F/4+1500 F/8 | 1.2 | 0.6 | 193.7 | 49.8 |
| | | | | | | | | | | | | | | | 239.2 | 3.4 | 198.3 | 40.6 |
| | | | | | | | | | | | | | | 2050F/4+1975 F/4+1650F/4 | 230.5 | 115.3 | 159.1 | 51.7 |
| | | | | | | | | | | | | | | | 117.5 | 1.2 | 191.7 | 46.7 |
| | | | | | | | | | | | | | | 1975F/4+1650 F/4 | 341.6 | 116.9 | | |
| | | | | | | | | | | | | | | | 299.2 | 93.5 | | |
| Ex. 3* | Bal | 6.73 | 0 | 1.94 | 5.97 | 6.3 | 5.62 | 9.97 | 3.03 | 0.09 | 0.03 | <0.01 | <0.001 | 1975F/4+1500 F/8 | 255.9 | 0.7 | 232.8 | 54.4 |
| | | | | | | | | | | | | | | | 2.3 | 2.9 | 281.4 | 52.2 |
| | | | | | | | | | | | | | | 2050F/4+1975 F/4+1650F/4 | 441.3 | 95.6 | 275.8 | 52.8 |
| | | | | | | | | | | | | | | | 205.9 | 108.7 | 246.2 | 56.2 |
| | | | | | | | | | | | | | | 1975F/4+1650 F/4 | 416.2 | 40.8 | | |
| | | | | | | | | | | | | | | | 351 | 214.3 | | |
| Ex. 4* | Bal | 7.55 | 0 | 1.92 | 5.94 | 6.33 | 5.63 | 10 | 2.99 | 0.09 | 0.03 | <0.01 | <0.001 | 1975F/4+1500 F/8 | 298.8 | 124.9 | 182.1 | 39.9 |
| | | | | | | | | | | | | | | | 405.8 | 114.8 | 186.5 | 41.5 |
| | | | | | | | | | | | | | | 2050F/4+1975 F/4+1650F/4 | 205.1 | 134.8 | 195.5 | 37.8 |
| | | | | | | | | | | | | | | | 90.5 | 115.1 | 186.3 | 41.1 |
| | | | | | | | | | | | | | | 1975F/4+1650 F/4 | 114.5 | 195.5 | | |
| | | | | | | | | | | | | | | | 579.4 | 145.9 | | |
| Ex. 5* | Bal | 7.94 | 0 | 1.95 | 6.02 | 6.28 | 5.61 | 10 | 2.98 | 0.1 | 0.03 | <0.01 | <0.001 | 1975F/4+1500 F/8 | 363.9 | 113.2 | 136.4 | 32.2 |
| | | | | | | | | | | | | | | | 468.1 | 127.0 | 140.7 | |
| | | | | | | | | | | | | | | 2050F/4+1975 F/4+1650F/4 | 233.8 | 132.6 | 140.1 | 36.6 |
| | | | | | | | | | | | | | | | 376.9 | 150.9 | 142.7 | 34.8 |
| | | | | | | | | | | | | | | 1975F/4+1650 F/4 | 207.3 | 115.3 | | |
| | | | | | | | | | | | | | | | 483.5 | 160.8 | | |
| Ex. 6* | Bal | 6.97 | 0 | 1.93 | 5.95 | 6.28 | 5.61 | 7.55 | 3.02 | 0.09 | 0.03 | <0.01 | <0.001 | 1975F/4+1500 F/8 | 297.4 | 95.5 | 202.0 | 43.1 |
| | | | | | | | | | | | | | | | 385.3 | 0.7 | 188.4 | 42.5 |
| | | | | | | | | | | | | | | 2050F/4+1975 F/4+1650F/4 | 231.5 | 133.3 | 167.5 | 41.6 |
| | | | | | | | | | | | | | | | 206.1 | 90.6 | 180.8 | |
| | | | | | | | | | | | | | | 1975F/4+1650 F/4 | 114.8 | 128.0 | | |
| | | | | | | | | | | | | | | | 188.9 | 186.6 | | |
| Ex. 7* | Bal | 6.88 | 0 | 1.95 | 5.94 | 6.25 | 5.57 | 5.06 | 3.06 | 0.09 | 0.03 | <0.01 | <0.001 | 1975F/4+1500 F/8 | 322.1 | 140.1 | 163.6 | 42.1 |
| | | | | | | | | | | | | | | | 356.2 | 115.2 | 196.4 | |
| | | | | | | | | | | | | | | 2050F/4+1975 F/4+1650F/4 | 455.7 | 144.1 | 149.6 | 40.4 |
| | | | | | | | | | | | | | | | 348.8 | 97.0 | 165.3 | 41.9 |
| | | | | | | | | | | | | | | 1975F/4+1650 F/4 | 533.7 | 138.9 | | |
| | | | | | | | | | | | | | | | 496.6 | 208.1 | | |
| Ex. 8* | Bal | 5.99 | 0 | 2.07 | 5.97 | 6.31 | 5.6 | 7.56 | 3.05 | 0.09 | 0.03 | <0.01 | <0.001 | 1975F/4+1500 F/8 | 256.8 | 106.2 | 194.4 | 43.3 |
| | | | | | | | | | | | | | | | 232.0 | 10.1 | 186.7 | 48.4 |
| | | | | | | | | | | | | | | 2050F/4+1975 F/4+1650F/4 | 255.3 | 107.1 | 209.8 | 51.1 |
| | | | | | | | | | | | | | | | 230.5 | 51.8 | 169.5 | 44.0 |
| | | | | | | | | | | | | | | | 245.6 | 1.5 | | |
| | | | | | | | | | | | | | | 1975F/4+1650 F/4 | 210.8 | 132.6 | | |
| Ex. 9 (within the claimed wordin g) | Bal | 7.0 | 0 | 2.0 | 4.0 | 8.8 | 5.6 | 10.1 | 3.0 | 0.11 | 0.03 | <0.01 | <0.001 | 1975F/4+1500 F/8 | 682.2 | | 251.9 | |
| | | | | | | | | | | | | | | 2050F/4+1975 F/4+1650F/4 | 803.3 | | | |
| Ex. 10* | Bal | 7.1 | 0 | 2.1 | 7.0 | 6.2 | 5.4 | 10.0 | 3.0 | 0.11 | 0.03 | <0.01 | <0.001 | 1975F/4+1500 F/8 | 430.2 | | 299.2 | |
| | | | | | | | | | | | | | | 2050F/4+1975 F/4+1650F/4 | 490.0 | | | |
| | | | | | | | | | | | | | | | 237.1 | | | |
| Prior Art 1 | Bal | 8 | 1.5 | 2 | 8 | 6 | 5 | 5 | 0 | | | | | 1975F/4+1550 F/24 | 234.3 | | | |
| | | | | | | | | | | | | | | | 227.8 | | | |
| Prior Art 2 | Bal | 6.5 | 1 | 0.6 | 6 | 6.5 | 5.6 | 9 | 3 | | | | | 2085F/2+1600 F/20 | 0.1 | | | |
| | | | | | | | | | | | | | | | 71.9 | | | |
| | | | | | | | | | | | | | | | 206.5 | | | |
| Prior Art 3 | Bal | 5 | 0 | 1.9 | 5.9 | 8.9 | 5.65 | 10 | 2 | 0.03 | 0.03 | <0.01 | <0.001 | 1975F/4+1500 F/8 | 0.7 min* | | 306 | 85.0 |
| | | | | | | | | | | | | | | | 401 max | | | |
| | | | | | | | | | | | | | | 1975F/4+1600 F/32 | 92.6 min | | | |
| | | | | | | | | | | | | | | | 517 max | | | |
| Prior Art 4 | Bal | 7 | 0 | 1.5 | 5 | 6.5 | 6.2 | 7.5 | 3 | 0.15 | 0.05 | 0.004 | 0.02 | 1975F/4+1500 F/8 | 263.9 | | | |
| | | | | | | | | | | | | | | 2050F/4+1975 F/4+1650F/4 | 247.3 | | 150.0 | 45.0 |
| | | | | | | | | | | | | | | 2050F/4+1975 F/4+1650F/4 | 410.1 | | | |

| | | | | | | | | | | | | | | | | | | |
|---|---|---|---|---|---|---|---|---|---|---|---|---|---|---|---|---|---|---|
| Prior Art 3 involved many samples and only the min. and max values are listed. *Included as reference examples | | | | | | | | | | | | | | | | | | |

**Table II**

| Alloy Compositional Ranges | | | | | | | | | | | | |
|---|---|---|---|---|---|---|---|---|---|---|---|---|
| Range | Elemental Weight Percentage | | | | | | | | | | | |
| | Ni | Cr | Mo | W | Ta | Al | Co | Re | Hf | C | B | Y |
| Range 1A | Bal | 6.7-7.5 | 1.8-2.3 | 3.7-7.3 | 6.0-9.0 | 5.3-5.9 | 4.75-10.3 | 2.8-3.2 | 0.08-0.15 | 0.03 | <0.01 | <0.001 |
| Range 1B | Bal | 6.8-7.2 | 1.8-2.2 | 3.8-7.2 | 6.1-8.9 | 5.35-5.7 | 4.9-10.2 | 2.9-3.1 | 0.09-0.12 | | | |
| Range 2A | Bal | 6.7-7.2 | 1.8-2.1 | 5.75-6.25 | 6.0-6.5 | 5.4-5.7 | 4.75-5.25 | 2.9-3.2 | 0.08-0.12 | | | |
| Range 2B | Bal | 6.8-7.1 | 1.85-2.0 | 5.8-6.1 | 6.1-6.4 | 5.5-5.7 | 4.9-5.2 | 3.0-3.2 | 0.08-0.11 | | | |
| Range 3A | Bal | 6.8-7.2 | 1.8-2.2 | 3.7-4.3 | 8.7-9.0 | 5.4-5.8 | 9.8-10.3 | 2.9-3.2 | 0.09-0.13 | | | |
| Range 3B | Bal | 6.9-7.1 | 1.9-2.1 | 3.8-4.2 | 8.7-8.9 | 5.5-5.7 | 9.9-10.1 | 2.9-3.1 | 0.10-0.12 | | | |
| Range 4A | Bal | 6.8-7.3 | 1.9-2.3 | 6.8-7.3 | 6.0-6.5 | 5.3-5.6 | 9.8-10.2 | 2.9-3.2 | 0.09-0.13 | | | |
| Range 4B | Bal | 6.9-7.2 | 2.0-2.2 | 6.9-7.1 | 6.1-6.3 | 5.3-5.5 | 9.9-10.1 | 2.9-3.1 | 0.10-0.12 | | | |

**Table III**

| Effect of heat Treatment on Prior Art 3 Min. and Max. Rupture Life (Hours) in Salt at 1500F-90ksi | | | | | |
|---|---|---|---|---|---|
| Heat Treat Type | Heat Treat Parameters | Final Heat Treat (FHT) * | Number of Samples | Rupture Life (Hours) | |
| | | | | Min. | Max. |
| N/A (As-Cast) | N/A | Y | 3 | 1.1 | 236.0 |
| Precipitation | 1300F/24hrs | N/A | 8 | 0.3 | 94.3 |
| | 1500F/8hrs | N/A | 29 | 1.1 | 401.2 |
| | 1600F/8hrs | N/A | 30 | 0.8 | 522.7 |
| | 1600F/32hrs | N/A | 27 | 92.6 | 517.0 |
| Solution | 2400F/30min | Y | 2 | 130.1 | 340.2 |
| | 2400/4hrs | Y | 2 | 327.7 | 398.7 |
| | 2400F/20hrs | Y | 2 | 399 | 406.5 |

| | | | | | |
|---|---|---|---|---|---|
| * 1975F/4hrs + 1600F/32hrs | | | | | |

One or more embodiments have been described. Nevertheless, it will be understood that various modifications may be made. For example, when applied to an existing baseline configuration, details of such baseline may influence details of particular implementations.

## Claims

1. An alloy comprising, by weight:
6.8% to 7.2% chromium;
1.8% to 2.2% molybdenum;
9.8% to 10.3% cobalt;
5.4% to 5.8% aluminum;
2.9% to 3.2% rhenium;
3.7% to 4.3% tungsten;
8.7% to 9.0% tantalum;
0.09% to 0.13% hafnium;
0% to 0.50% titanium;
0% to 0.01% boron;
0% to 0.02% yttrium;
0 to 5ppm sulfur;
0% to 0.50% silicon;
0% to 0.10% carbon;
0% to 0.05% yttrium, lanthanum, and/or cerium combined; and
balance nickel.

2. The alloy of claim 1 wherein, by weight, one or more of:
a sulfur content, if any, is no more than 1 ppm; and
a silicon content, if any, is no more than 0.30%.

3. The alloy of any one of the preceding claims wherein, by weight:
the combined content of chromium, cobalt, and aluminum is 17.0% to 23.0%, preferably 17.5% to 22.5%.

4. The alloy of any one of the preceding claims wherein, by weight:
the combined content of tungsten and tantalum is 12.0% to 13.0%, and/or
the combined content of rhenium, tungsten, and tantalum is 10.0% to 15.5%.

5. The alloy of any one of the preceding claims having one to all of the following properties:
an average 1500F/90ksi (1089K/621MPa) salt rupture life of at least 300 hours;
an average 1500F/100 ksi (1089K/689 MPa) salt rupture life of at least 100 hours;
an average 1800F/36 ksi (1255K/248 MPa) air rupture life of at least 140 hours; and
an average 1850F/38 ksi (1283K/262 MPa) air rupture life of at least 38 hours
wherein the properties are measured as defined herein.

6. The alloy of any one of the preceding claims in single-crystal (SX) form.

7. Use of a substrate formed of the alloy of any preceding claim in a turbine blade.

8. Use of the substrate of claim 7, wherein the turbine blade comprises:
an attachment root;
an airfoil extending from a proximal end to a tip; and
a platform between the airfoil and the attachment root.

9. Use of the substrate of claim 7 or claim 8, wherein the turbine blade further comprises:
a thermal barrier coating atop the substrate at least along the airfoil.

10. Use of the substrate of claim 9, wherein the thermal barrier coating is not along the root and platform underside.

11. A method of heat treatment of the alloy of any one of claims 1-6, the method comprising:
a solution heat treat for a period of at least 4.0 hours; and
after the solution heat treat, a final aging precipitation heat at a temperature of 1575F (1130K) to 1675F (1186K) for a period of 4.0 hours to 32.0 hours.

## Patentansprüche

1. Legierung, umfassend, bezogen auf das Gewicht:
6,8 % bis 7,2 % Chrom;
1,8 % bis 2,2 % Molybdän;
9,8 % bis 10,3 % Kobalt;
5,4 % bis 5,8 % Aluminium;
2,9 % bis 3,2 % Rhenium;
3,7 % bis 4,3 % Wolfram;
8,7 % bis 9,0 % Tantal;
0,09 % bis 0,13 % Hafnium;
0 % bis 0,50 % Titan;
0 % bis 0,01 % Bor;
0 % bis 0,02 % Yttrium;
0 bis 5 ppm Schwefel;
0 % bis 0,50 % Silizium;
0 % bis 0,10 % Kohlenstoff;
0 % bis 0,05 % Yttrium, Lanthan und/oder Cer kombiniert; und als Rest Nickel.

2. Legierung nach Anspruch 1, wobei, bezogen auf das Gewicht, eines oder mehrere von:
dem Schwefelgehalt, sofern vorhanden, nicht mehr als 1 ppm beträgt; und
dem Siliziumgehalt, sofern vorhanden, nicht mehr als 0,30 % beträgt.

3. Legierung nach einem der vorhergehenden Ansprüche, wobei, bezogen auf das Gewicht:
der kombinierte Gehalt an Chrom, Kobalt und Aluminium 17,0 % bis 23,0 %, vorzugsweise 17,5 % bis 22,5 %, beträgt.

4. Legierung nach einem der vorhergehenden Ansprüche, wobei, bezogen auf das Gewicht:
der kombinierte Gehalt an Wolfram und Tantal 12,0 % bis 13,0 % beträgt und/oder
der kombinierte Gehalt an Rhenium, Wolfram und Tantal 10,0 % bis 15,5 % beträgt.

5. Legierung nach einem der vorhergehenden Ansprüche, die eine oder alle der folgenden Eigenschaften aufweist:
eine durchschnittliche Lebensdauer bis zum Bruch aufgrund von Salz von mindestens 300 Stunden bei 1500 F/90 ksi (1089 K/621 MPa);
eine durchschnittliche Lebensdauer bis zum Bruch aufgrund von Salz von mindestens 100 Stunden bei 1500 F/100 ksi (1089 K/689 MPa);
eine durchschnittliche Lebensdauer bis zum Bruch aufgrund von Salz von mindestens 140 Stunden bei 1800 F/36 ksi (1255 K/248 MPa); und
eine durchschnittliche Lebensdauer bis zum Bruch aufgrund von Salz von mindestens 38 Stunden bei 1850 F/38 ksi (1283 K/262 MPa),
wobei die Eigenschaften wie hierin definiert gemessen werden.

6. Legierung nach einem der vorhergehenden Ansprüche in monokristalliner (SX) Form.

7. Verwendung eines aus der Legierung nach einem der vorhergehenden Ansprüche gebildeten Substrats in einer Turbinenschaufel.

8. Verwendung des Substrats nach Anspruch 7, wobei die Turbinenschaufel Folgendes umfasst:
eine Befestigungswurzel;
ein Schaufelblattprofil, das sich von einem proximalen Ende zu einer Spitze erstreckt; und
eine Plattform zwischen dem Schaufelblatt und der Befestigungswurzel.

9. Verwendung des Substrats nach Anspruch 7 oder Anspruch 8, wobei die Turbinenschaufel ferner Folgendes umfasst:
eine Wärmedämmschicht auf dem Substrat mindestens entlang des Schaufelblatts.

10. Verwendung des Substrats nach Anspruch 9, wobei sich die Wärmedämmschicht nicht entlang der Wurzel und der Plattformunterseite befindet.

11. Verfahren zur Wärmebehandlung der Legierung nach einem der Ansprüche 1-6, wobei das Verfahren Folgendes umfasst:
ein Lösungsglühbehandeln für einen Zeitraum von mindestens 4,0 Stunden; und
ein abschließendes Alterungsauslagerungsbehandeln bei einer Temperatur von 1575 F (1130 K) bis 1675 F (1186 K) für einen Zeitraum von 4,0 Stunden bis 32,0 Stunden nach dem Lösungsglühbehandeln.

## Revendications

1. Alliage comprenant, en poids:
6,8 % à 7,2 % de chrome ;
1,8 % à 2,2 % de molybdène ;
9,8 % à 10,3 % de cobalt ;
5,4 % à 5,8 % d'aluminium ;
2,9 % à 3,2 % de rhénium ;
3,7 % à 4,3 % de tungstène ;
8,7 % à 9,0 % de tantale ;
0,09 % à 0,13 % d'hafnium ;
0 % à 0,50 % de titane ;
0 % à 0,01 % de bore ;
0 % à 0,02 % d'yttrium ;
0 à 5 ppm de soufre ;
0 % à 0,50 % de silicium ;
0 % à 0,10 % de carbone ;
0 % à 0,05 % d'yttrium, de lanthane et/ou de cérium combinés ;
et le reste est du nickel.

2. Alliage selon la revendication 1, dans lequel, en poids, un ou plusieurs des éléments suivants:
une teneur en soufre, le cas échéant, ne dépasse pas 1 ppm ; et
une teneur en silicium, le cas échéant, ne dépasse pas 0,30 %.

3. Alliage selon l'une quelconque des revendications précédentes, dans lequel, en poids:
la teneur combinée en chrome, cobalt et aluminium est de 17,0 % à 23,0 %, de préférence de 17,5 % à 22,5 %.

4. Alliage selon l'une quelconque des revendications précédentes, dans lequel, en poids:
la teneur combinée en tungstène et en tantale est de 12,0 % à 13,0 %, et/ou
la teneur combinée en rhénium, tungstène et tantale est de 10,0 % à 15,5 %.

5. Alliage selon l'une quelconque des revendications précédentes, présentant l'une à l'ensemble des propriétés suivantes :
une durée de vie moyenne à la rupture par fluage en environnement salin d'au moins 300 heures à 1500°F/90 ksi (1089 K/621 MPa) ;
une durée de vie moyenne à la rupture par fluage en environnement salin d'au moins 100 heures à 1500°F/100 ksi (1089 K/689 MPa) ;
une durée de vie moyenne à la rupture à l'air d'au moins 140 heures à 1800 °F/36 ksi (1255 K/248 MPa) ; et
une durée de vie moyenne à la rupture à l'air d'au moins 38 heures de 1850 °F/38 ksi (1283 K/262 MPa)
dans lequel les propriétés sont mesurées comme définies ici.

6. Alliage selon l'une quelconque des revendications précédentes sous forme monocristalline (SX).

7. Utilisation d'un substrat formé de l'alliage selon une quelconque revendication précédente dans une aube de turbine.

8. Utilisation du substrat selon la revendication 7, dans laquelle l'aube de turbine comprend:
une racine de fixation;
un profil aérodynamique s'étendant d'une extrémité proximale à une pointe ; et
une plateforme entre le profil aérodynamique et la racine de fixation.

9. Utilisation du substrat selon la revendication 7 ou la revendication 8, dans laquelle l'aube de turbine comprend également:
un revêtement barrière thermique sur le substrat au moins le long du profil aérodynamique.

10. Utilisation du substrat selon la revendication 9, dans laquelle le revêtement de barrière thermique ne se trouve pas le long de la racine et de la face inférieure de la plateforme.

11. Procédé de traitement thermique de l'alliage selon l'une quelconque des revendications 1 à 6, le procédé comprenant:
un traitement thermique de mise en solution pendant une période d'au moins 4,0 heures ; et
après le traitement thermique de mise en solution, un traitement thermique de précipitation de vieillissement final à une température de 1575 °F (1130 K) à 1675 °F (1186 K) pendant une période de 4,0 heures à 32,0 heures.
